Europäisches Patentamt

European Patent Office

Office européen des brevets

(11) Veröffentlichungsnummer: **0 159 524**
**B1**

(12) **EUROPÄISCHE PATENTSCHRIFT**

(45) Veröffentlichungstag der Patentschrift:
**15.11.89**

(51) Int. Cl.⁴: **H 03 C 1/62**

(21) Anmeldenummer: **85103048.6**

(22) Anmeldetag: **16.03.85**

(54) Amplitudenmodulierter Sender mit Anoden-B-Modulation.

(30) Priorität: **03.04.84 CH 1690/84**

(43) Veröffentlichungstag der Anmeldung:
**30.10.85 Patentblatt 85/44**

(45) Bekanntmachung des Hinweises auf die Patenterteilung:
**15.11.89 Patentblatt 89/46**

(84) Benannte Vertragsstaaten:
**CH DE FR GB LI NL**

(56) Entgegenhaltungen:
**EP-A-0 054 981**
**CH-A-634 183**
**DE-A-661 312**

(73) Patentinhaber: **BBC Brown Boveri AG,
Haselstrasse, CH- 5401 Baden (CH)**

(72) Erfinder: **Kyrian, Bohumil, Dipl.- Ing., Ursprung 293,
CH- 5224 Unterbözberg (CH)**

## Beschreibung

Die vorliegende Erfindung geht aus von einem amplitudenmodulierten Sender mit Anoden-B-Modulation gemäss dem Oberbegriff des Anspruchs 1. Ein solcher Sender ist aus der EP-A-0 054 981 bekannt.

Bei dem bekannten Sender, der aufgrund der Anoden-B-Modulation schon an sich einen relativ hohen Wirkungsgrad, d.h. ein relativ gutes Verhältnis von abgestrahlter Hochfrequenzleistung zu eingespeister Versorgungsleistung aufweist, wird eine weitere Verbesserung dieses Wirkungsgrads dadurch erreicht, dass die Versorgungsspannung des verwendeten Anoden-B-Modulators in Abhängigkeit von der Dynamik des niederfrequenten Eingangssignals verändert wird. Insbesondere wird bei Programmpausen oder längerdauernden leisen Stellen innerhalb des Senderprogramms die Verlustleistung des Anoden-B-Modulators reduziert, so dass eine deutliche Energieeinsparung gegenüber dem Sendebetrieb mit ungesteuertem Anoden-B-Modulator zu verzeichnen ist.

Es ist weiterhin aus der CH-A-634 183 bekannt, zur Wirkungsgradverbesserung eines amplitudenmodulierten Senders der Modulationsstufe eines solchen Senders eine von der Dynamik des niederfrequenten Eingangssignals abhängige Steuergrösse zuzuführen und durch Verschiebung des Arbeitspunktes auf der Modulationskennlinie ein trägergesteuertes AM-Signal zu erzeugen, das in einem Hauptsender auf die Abstrahlleistung verstärkt wird.

Es ist darüber hinaus auch aus der CH-A-634 183 bekannt, diese Modulationsstufe als Senderendröhre zur Anoden-Modulation auszuführen, wenn als Modulationsverstärker ein pulsdauermodulierter Schaltverstärker verwendet wird.

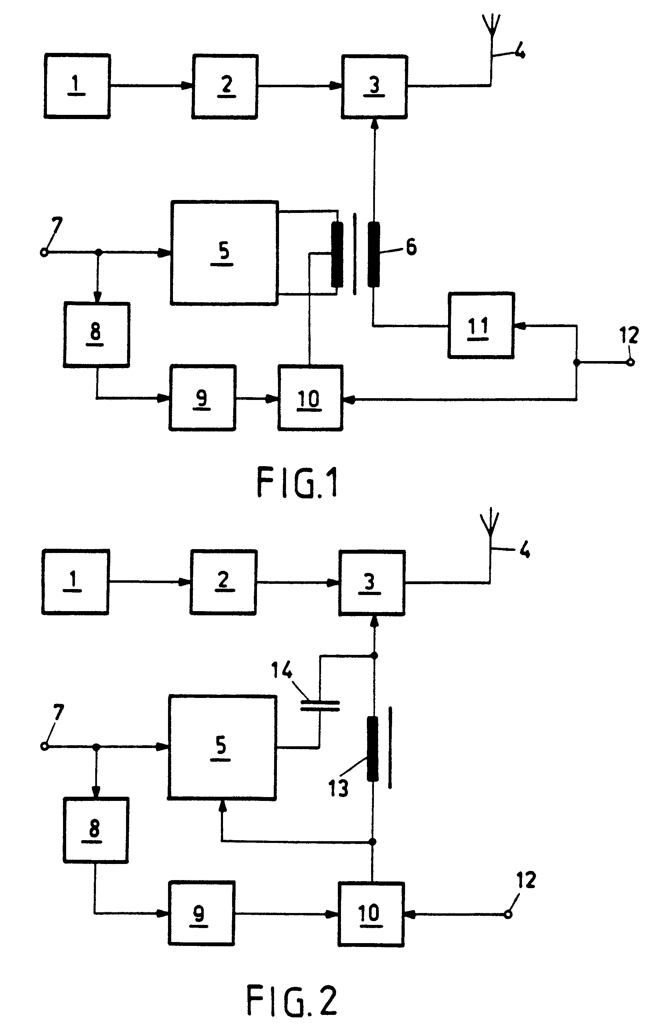

Während der zuerst beschriebene, aus der EP-A-0 054 981 bekannte Sender eine Wirkungsgradverbesserung nur durch die dynamikabhängige Steuerung der Versorgungsspannung des Anoden-B-Modulators erreicht, jedoch eine weitere Erhöhung des Wirkungsgrads durch Trägersteuerung ausser acht lässt, zielen die Lehren der CH-A-634 183 auf eine Wirkungsgradverbesserung durch eine Trägersteuerung, die entweder mit stark verlustbehafteten Leistungsverstärkern und Hauptsendern arbeitet (Fig. 1 dieser Patentschrift), oder den Einsatz eines speziellen, pulsdauermodulierten Schaltverstärkers notwendig macht (Fig. 2 dieser Patentschrift).

Es ist andererseits aus der DE-A-661 312 bekannt, bei einem Sender an der Endröhre mit einer gleitenden Anodenspannung zu arbeiten, die vom niederfrequenten Eingangssignal gesteuert wird. Verwendet wird in diesem Fall jedoch die Gitterspannungsmodulation, bei der Modulationssignal und Anodenspannung von vornherein getrennt sind.

Der vorliegenden Erfindung liegt daher die Aufgabe zugrunde, einen amplitudenmodulierten Sender mit Anoden-B-Modulation zu schaffen, der bei geringem Aufwand einen möglichst hohen Wirkungsgrad aufweist und zudem durch geringfügige Änderungen in herkömmlichen Sendern mit Anoden-B-Modulation realisiert werden kann.

Bei einem Sender der eingangs genannten Art wird die Aufgabe durch die Merkmale aus dem Kennzeichen des Anspruchs 1 gelöst.

Die gleichzeitige Steuerung der Versorgungsspannung des Anoden-B-Modulators und der Anodenspannung der Endstufe in Abhängigkeit von der Hüllkurve des niederfrequenten Eingangssignals führt zu einer besonders drastischen Verbesserung des Wirkungsgrads, ohne dass die wesentlichen Komponenten des Senders, der Anoden-B-Modulator und die Endstufe geändert werden müssen.

Besonders vorteilhaft ist es, gemäss einer Weiterbildung der Erfindung für die Steuerung beider Spannungen denselben steuerbaren Gleichrichter, denselben Spitzenwertdetektor und dasselbe Aufbereitungsglied zu verwenden, weil damit eine erhebliche Einsparung an Investitionskosten verbunden ist.

Die Erfindung soll nun nachfolgend im Zusammenhang mit der Zeichnung anhand von Ausführungsbeispielen näher erläutert werden. Es zeigen:

Fig. 1 einen amplitudenmodulierten Sender mit Anoden-B-Modulator und Steuerung der Versorgungsspannung nach dem Stand der Technik;

Fig. 2 das Ausführungsbeispiel eines amplitudenmodulierten Senders nach der Erfindung.

Der in Fig 1 im Blockschaltbild dargestellte Sender nach dem Stand der Technik enthält in der HF-Kette einen Oszillator 1 zur Erzeugung der Trägerschwingung, eine Treiberstufe 2 zur Verstärkung der Trägerschwingung und eine Endstufe 3, die üblicherweise mit einer als Hochleistungstetrode ausgebildeten Endröhre bestückt ist, an deren Steuergitter die verstärkte Trägerschwingung aus der Treiberstufe 2 anliegt und deren Anodenspannung über die Sekundärwicklung eines Modulationstransformators 6 von einem ungesteuerten Gleichrichter 11 herangeführt wird, der seinerseits mit einem Netzanschluss 12 verbunden ist.

Die NF-Kette des bekannten Senders enthält einen Anoden-B-Modulator 5 mit üblicherweise zwei Hochleistungsröhren in Gegentaktschaltung, deren Anoden an die Primärwicklung des Modulationstransformators 6 angeschlossen sind und über eine Mittelanzapfung der Primärwicklung aus einem steuerbaren Gleichrichter 10 mit Anodenspannung versorgt werden.

Der steuerbare Gleichrichter 10 ist gleichfalls mit dem Netzanschluss 12 verbunden und erhält seine Steuerspannung aus einem Aufbereitungsglied 9, dessen Eingang mit dem Ausgang eines vorgeschalteten Spitzenwertdetektors 8 verbunden ist. Sowohl der Eingang des Anoden-B-Modulators 5 als auch der Eingang des Spitzenwertdetektors 8 sind mit einem NF-Eingang 7 verbunden, an dem das niederfrequente Eingangssignal, mit dem die Trägerschwingung moduliert werden soll, anliegt.

Der Spitzenwertdetektor 8 leitet aus dem niederfrequenten Eingangssignal eine der Dynamik dieses Signals entsprechende Hüllkurvenspannung ab. Im Aufbereitungsglied 9 wird die Hüllkurvenspannung verstärkt, und durch Komparatoren, Addierwerke und Zeitglieder eine Steuerspannung für den gesteuerten Gleichrichter 10 erzeugt, die eine vorgegebene Abhängigkeit von der Zeit und der Amplitude des niederfrequenten Eingangssignals aufweist und als Sollwert für die Gleichrichtersteuerung dient.

In Fig. 2 ist demgegenüber ein bevorzugtes Ausführungsbeispiel des erfindungsgemässen Senders mit Trägersteuerung dargestellt, wobei gleichartige Funktionsblöcke mit denselben Ziffern aus der Fig. 1 bezeichnet sind. Der Modulationstransformator 6, der in der bekannten Senderschaltung nach Fig. 1 die Überlagerung des verstärkten NF-Signals mit der konstanten Anodenspannung für die Endstufe 3 bewirkt, fehlt in der Schaltung nach Fig. 2 völlig. Die Endstufe 3 wird hier direkt von dem steuerbaren Gleichrichter 10 über eine Modulationsdrossel 13 mit der erforderlichen und veränderlichen Anodenspannung versorgt. Die Modulationsdrossel 13 dient dabei der Trennung des vom Anoden-B-Modulator 5 kommenden NF-Signalpfades und des Anodenversorgungspfades über den vom gesteuerten Gleichrichter 10 eine zeitlich nur langsam sich ändernde Anodenspannung herangeführt wird.

Die Ausgangsspannung des gesteuerten Gleichrichters 10 wird vor der Modulationsdrossel 13 abgegriffen und gleichzeitig als Versorgungsspannung des Anoden-B-Modulators 5 verwendet, so dass sowohl die Trägerleistung der Endstufe 3 als auch die Verlustleistung des Anoden-B-Modulators in Abhängigkeit von der Hüllkurve des niederfrequenten Eingangssignals verändert werden.

Die Einkopplung des im Anoden-B-Modulator verstärkten Modulationssignals erfolgt über einen Modulationskondensator 14 auf den Modulationseingang der Endstufe 3, an dem auch die Anodenspannung anliegt.

Die Aufbereitung der Hüllkurvenspannung im Aufbereitungsglied 9 zur Erzeugung einer Steuerspannung für den steuerbaren Gleichrichter 10 erfolgt nach an sich bekannten Prinzipien, wie sie in der EP-A-0 054 981 angegeben sind, wobei vorzugsweise eine Trägersteuerungskennlinie zugrundegelegt wird, die bei grossen Amplituden des niederfrequenten Eingangssignals die Trägerschwingungsamplitude proportional vergrössert, bei mittleren Amplituden konstant hält und bei kleinen Amplituden wiederum anhebt.

Insgesamt zeichnet sich der erfindungsgemässe Sender durch einen besonders hohen Wirkungsgrad aus, lässt sich vergleichsweise einfach aufbauen und kann unter Beibehaltung der HF- und NF-Kette mit nur geringen Änderungen aus bereits bestehenden Sendern mit Anoden-B-Modulation realisiert werden.

**Patentansprüche**

1. Amplitudenmodulierter Sender mit Anoden-B-Modulation, bei dem ein niederfrequentes Eingangssignal in einem Anoden-B-Modulator (5) verstärkt und zur Modulation einer Trägerschwingung an eine Endstufe (3) weitergeleitet wird, und bei dem für die Stromversorgung des Anoden-B-Modulators (5) ein steuerbarer Gleichrichter (10) vorgesehen ist, welcher steuerbare Gleichrichter (10) über einen Spitzenwertdetektor (8) und ein nachfolgendes Aufbereitungsglied (9) mit einem NF-Eingang (7) für das niederfrequente Eingangssignal verbunden ist und die Versorgungsspannung des Anoden-B-Modulators (5) in Abhängigkeit von der Hüllkurve des niederfrequenten Eingangssignals steuert, dadurch gekennzeichnet, dass für eine Trägersteuerung

- erste Mittel zur Steuerung der Anodenspannung der Endstufe (3) vorgesehen sind;
- zweite Mittel zur Ableitung der Hüllkurve des niederfrequenten Eingangssignals vorgesehen sind;
- die zweiten Mittel mit den ersten Mitteln in Wirkverbindung stehen, derart, dass die mittlere Amplitude der Trägerschwingung nach Massgabe einer Trägersteuerungskennlinie in Abhängigkeit von der Hüllkurve des niederfrequenten Eingangssignals gesteuert wird;
- das im Anoden-B-Modulator (5) verstärkte niederfrequente Eingangssignal über einen Modulationskondensator (14) auf den Anodenspannungseingang der Endstufe (3) gelangt; und
- die Ausgangsspannung der ersten Mittel über eine Modulationsdrossel (13) auf den Anodenspannungseingang der Endstufe (3) gelangt.

2. Amplitudenmodulierter Sender nach Anspruch 1, dadurch gekennzeichnet, dass als erste Mittel der steuerbare Gleichrichter (10) und als zweite Mittel der Spitzenwertdetektor (8) und das nachfolgende Aufbereitungsglied (9) vorgesehen sind.

3. Amplitudenmodulierter Sender nach Anspruch 2, dadurch gekennzeichnet, dass der steuerbare Gleichrichter (10) mit steuerbaren Leistungshalbleitern, vorzugsweise Thyristoren, aufgebaut ist.

**Claims**

1. Amplitude-modulated transmitter with class B anode modulation, in which a low-frequency input signal is amplified in a class B anode modulator (5) and is fed to an out-put stage (3) for modulating a carrier oscillation, and in which a controllable rectifier (10) is provided for supplying power to the class B anode modulator (5), which controllable rectifier (10) is connected via a peak-value detector (8) and a subsequent processing section (9) to an LF input (7) for the low-frequency input signal and controls the supply voltage of the class B anode modulator (5) as a function of the envelope curve of the low-frequency input signal, characterised in that for a carrier control

- first means are provided for controlling the anode voltage of the output stage (3);
- second means are provided for deriving the envelope curve of the lowfrequency input signal;
- the second means are effectively connected to the first means in such a manner that the mean amplitude of the carrier oscillation is controlled in accordance with a carrier control characteristic in dependence on the envelope curve of the low-frequency input signal;
- the low-frequency input signal amplified in the class B anode modulator (5) passes via a modulation capacitor (14) to the anode voltage input of the output stage (3); and
- the output voltage of the first means passes via a modulation choke (13) to the anode voltage input of the output stage (3).

2. Amplitude-modulated transmitter according to Claim 1, characterised in that as first means, the controllable rectifier (10), and as second means, the peak-value detector (8) and the subsequent processing section (9) are provided.

3. Amplitude-modulated transmitter according to Claim 2, characterised in that the controllable rectifier (10) is constructed with controllable power semiconductors, preferably thyristors.

**Revendications**

1. Emetteur modulé en amplitude par une modulation d'anode type B, dans lequel un signal d'entrée à basse fréquence est amplifié dans un modulateur d'anode type B (5) et est envoyé à un étage de sortie (3) pour la modulation d'une onde porteuse, et dans lequel il est prévu un redresseur contrôlable (10) pour l'alimentation en courant du modulateur d'anode type B (5), lequel redresseur contrôlable (10) est raccordé à une entrée BF (7) pour le signal d'entrée à basse fréquence via un détecteur de valeur de crête (8) suivi d'un organe de préparation (9), et contrôle la tension d'alimentation du modulateur d'anode type B (5) en fonction de la courbe enveloppe du signal d'entrée à basse fréquence, caractérisé en ce que pour un contrôle de l'onde porteuse:

- il est prévu des premiers moyens pour contrôler la tension anodique de l'étage de sortie (3);
- il est prévu des seconds moyens pour dériver la courbe enveloppe du signal d'entrée à basse fréquence;
- les seconds moyens sont en liaison active avec les premiers moyens, de telle sorte que l'amplitude moyenne de l'onde porteuse est contrôlée, conformément à un diagramme caractéristique du contrôle de la porteuse, en fonction de la courbe enveloppe du signal d'entrée à basse fréquence;
- le signal d'entrée à basse fréquence amplifié dans le modulateur d'anode type B (5) arrive à l'entrée de la tension anodique de l'étage de sortie (3) via un condensateur de modulation (14); et
- la tension de sortie des premiers moyens arrive à l'entrée de la tension anodique de l'étage de sortie (3) via une self de modulation (13).

2. Emetteur modulé en amplitude suivant la revendication 1, caractérisé en ce qu'en guise de premiers moyens il est prévu le redresseur contrôlable (10) et en guise de seconds moyens le détecteur de valeur de crête (8) et l'organe de préparation (9) qui le suit.

3. Emetteur modulé en amplitude suivant la revendication 2, caractérisé en ce que le redresseur contrôlable (10) est équipé de semi-conducteurs de puissance contrôlables, de préférence de thyristors.

FIG.1

FIG.2